# EUROPEAN PATENT APPLICATION

(11) **EP 0 790 328 A1**
(43) Date of publication of application: **20.08.1997**
(21) Application number: 97300843.6
(22) Date of filing: 10.02.1997
(51) Int. Cl.: C23C 14/34, H01J 37/34

(54) **Thin film deposition**

(30) Priority: 13.02.1996 GB 9602948
(71) Applicant: The BOC Group plc, Windlesham Surrey GU20 6HJ (GB)
(72) Inventor: Thwaites, Michael John, Basingstoke, Hampshire RG27 9PF (GB)
(74) Representative: Bousfield, Roger James

(57) **Abstract**

A process of depositing thin film coatings by sputtering which comprises
- forming a plasma in an evacuated chamber;
- providing a source of material to be sputtered;
- locating a substrate to be coated in the chamber;
- causing the sputtered material to pass through the plasma and be deposited in the substrate
wherein the plasma is generated by a helicon wave.

## Description

This invention relates to methods and apparatus for the deposition of thin films and, more particularly, to the deposition of such films by means of an improved sputtering process.

It has been known for many years that thin film deposition processes and the properties of the deposited films themselves can be improved by allowing energetic ions to impinge on the growing surface of the film being deposited; this is due to an energy transfer between the energetic ions and the so-called "adatoms" of the thin film being deposited. This increases the surface mobility of the adatoms and allows them to migrate more easily to the preferred lattice sites.

A convenient way of effecting energetic ion impingement is to operate the deposition process in a plasma present in the process chamber, for example in sputtering, plasma enhanced chemical vapour deposition (PECVD) and ion assisted evaporation processes.

In the case of sputtering processes in particular, these are widely used for depositing thin coatings or films of materials on to substrates. Such processes take place in an evacuated chamber containing a small quantity of an ionisable gas, for example argon; electrons emitted from a source held within the chamber ionise the gas to form a plasma; a target comprising the material to be sputtered is bombarded by ions causing atoms of the target material to be dislodged and subsequently deposited as a film on the substrate being coated.

It is well known that in magnetron apparatus the rate of deposition may be increased by the use of magnetic means, for example an array of permanent magnets positioned in a predetermined manner (commonly as a closed loop), associated with the cathode target to create in use a plasma which is localised along a sputtering zone of the target and thereby to define the area or region, from which sputtering, or erosion of the target, occurs.

The target is commonly of flat, elongate and rectangular form and the substrate being coated is moved continuously or intermittently relative to the target during the sputtering process. Apparatus having such a target and having magnetic means of the type described above is known as a planar magnetron.

One disadvantage of the conventional planar magnetron is that the area of the target from which the sputtering takes place (commonly referred to as the "race track") is relatively small and this causes erosion of the target surface in a relatively small, for example ring-shaped, region corresponding to the shape of the closed loop magnetic field. Thus, only a small portion of the total target surface area is consumed before the target needs replacing.

It is also known, however, to replace the planar target with a hollow cylindrical one comprising, or having the outer surface thereof coated with, the material to be sputtered. Apparatus containing such a target is known as a cylindrical magnetron and is sold by BOC Coating Technology (a division of the Applicants) under the trade mark "C-Mag".

In cylindrical magnetron apparatus, the cylindrical target is rotatable about its longitudinal axis either continuously or intermittently during use so that sputtering is not confined to one particular area of the target surface. As with the planar magnetron, the substrate being coated is moved, again either continuously or intermittently, relative to the target in a direction transverse to the longitudinal axis of the target.

The magnetron means in the form of an array of permanent magnets are generally held stationary within the cylindrical target whilst (in use) the latter rotates. However, some adjustment of the magnet array relative to the target is normally possible for overall adjustment prior to each sputtering process. Such apparatus therefore allows a much greater amount of the target to be consumed in the sputtering process by selectively bringing different portions of the target into a sputtering position in respect of the magnetic field formed by the magnets.

Nevertheless, the use of such magnet means in either a planar magnetron or in a cylindrical magnetron apparatus clearly renders the apparatus as a whole very complicated and imposes on the apparatus certain constraints on the amount of target that can be economically utilised.

The use of magnetron assisted sputtering is based on the principle that electrons are trapped in a closed path (the "race track") in front of the sputter target using crossed electric and magnetic fields; the trapped electrons generate high argon in concentrations near the target and a high sputter target results. However, the fact that the shape of the race track is determined by an array of magnets mounted behind the target means that the technique is generally restricted to use with target of low magnetic permeability. there are therefore difficulties in forming useful deposits of magnetic materials using magnetron assisted techniques.

A further problem that may be encountered with magnetron assisted sputtering is that the surface of the target away from the "race track" may become poisoned by the deposition or formation thereon of unwanted coatings, for example the formation of an aluminium oxide coating on the surface of an aluminium target, which can act as an insulator and cause the target to act as a capacitor, leading to plasma instability and a reduced reproducibility of the required sputtered deposit.

The present invention provides an improved sputtering deposition process which generally allows for efficient deposition of thin film without the need to use magnetic means in the apparatus for conducting the process, thereby allowing for one or more of:
i) a higher target utilisation by eliminating the "race track",
ii) an ability to form deposits of magnetic materials including iron, nickel and cobalt, and
iii) a higher reproducibility of deposit.

In accordance with the invention, there is provided a process of depositing thin film coatings by sputtering which comprises:
- forming a plasma in an evacuated chamber;
- providing a source of material to be sputtered;
- locating a substrate to be coated in the chamber;
- causing the sputtered material to pass through the plasma and be deposited in the substrate
wherein the plasma is generated by a helicon wave.

A helicon wave is known per se and can be produced in a chamber at high vacuum by interaction between a substantially uniform magnetic field and an electric field profile of an external antenna operating at a radio frequency (rf). Wave energy from the antenna emissions is transferred to the electrons produced in a plasma, for example argon, discharge present in the chamber by the well known mechanism know as Landau damping; in the case of helicon waves in particular, energy exchange is thought to occur in a much more efficient manner than with other types of discharge.

Radio frequency discharges of 13.56 MHz are preferred although related frequencies of 6.78 and 27.12 MHz could also usefully be employed.

The pressure in the deposition chamber should be from 10⁻² to 10⁻³ mbar or lower to ensure the production of plasma, for example an argon plasma. Depending on the general process parameters, it may be necessary to introduce baffle plates in to the process chamber to vary the pressure in different parts of the chamber.

The invention is especially useful in processes for the reactive sputtering of thin films in which a gaseous element or compound to be co-deposited with the sputtered material is present in the chamber.

The invention can usefully be performed in a chamber in which, or about which, field coils are present to effect a substantially uniform magnetic field (commonly cylindrical) in a pre-determined area of the chamber. Three such field coils spaced along the length of the relevant part of the chamber are generally sufficient; preferably the coils are present in a linear array. At one end of the array is positioned the rf antenna to cause, in use of the process of the invention, the intense helicon plasma wave, produced by interaction between the magnetic field and the rf power supply, which in turn accelerates plasma electrons by the mechanism of Landau damping.

For a better understanding of the invention, reference will now be made, by way of exemplification only, to the accompany drawing which shows a schematic cross sectional representation of a chamber in which the process of the invention can be performed.

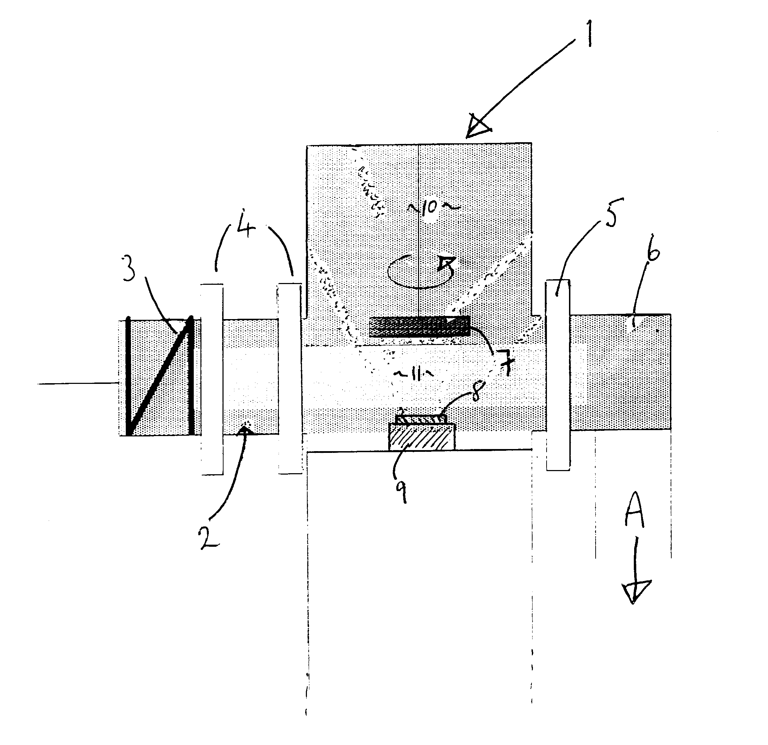

The drawing shows a process chamber generally shown at 1 about an external surface of a generally cylindrical end 2 of which is positioned a radio frequency antenna 3 and two field coils 4.

A third field coil 5 is positioned about a generally cylindrical end 6 of the process chamber 1 such that the three field coils form a substantially linear array about a central part of the chamber 1.

At the top of the central part of the chamber 1 is positioned a target 7 of the substance to be sputtered, for example indium.

In the lower part of the chamber 1 is positioned a substrate 8 held in place by a substrate holder 9. The substrate can be of any suitable size or shape. As shown in the drawing, it is a stationary substrate but the coalescing apparatus may be modified to accommodate a moving substrate which slowly passes in to the apparatus for the coating to occur and then out of the apparatus on a continuous basis.

Vacuum pumps (not shown) are provided to evacuate the chamber 1 in the direction shown by the arrow A. Evacuation can usefully be effected by means of a turbo-molecular plus backing (rotary) pump system or by means of a diffusion pump plus rotary pump system or an additional turbo-molecular pump plus backing (rotary) pump.

In use of the apparatus shown in the drawing, the vacuum pump systems are operated to produce a vacuum in the upper and central parts of the chamber 1 of, typically above about 1 x 10⁻³.

The chamber 1 itself was initially pumped down to 1 x 10⁻⁵ mbar. Pure oxygen (as the reactive gas) and pure argon (as the plasma gas) were injected into the chamber 1 such that their partial pressures were about 3 x 10⁻⁴ mbar and 1 x 10⁻³ mbar respectively.

The three field coils 4, 4, 5 were set to produce a uniform magnetic field of about 200 Gauss and the antenna 3 set at an rf power of about 2KW and a frequency of 13.56 MHz. This produced a plasma throughout the chamber 1 (at least in the upper and central parts thereof) as shown by reference numeral 10 of a fairly uniform (blue/pink) colour characteristic of predominantly excited argon, with a central predetermined region within the field coil array of a cylindrical central plasma shown by the reference arrow 11 characteristic of a mainly ionised argon plasma; the latter was the helicon plasma wave.

By virtue of negative biassing of the substrate 8/9 relative to the positive argon ions of the plasma, the ions bombard the target and material is sputtered off the surface thereof in a relatively uniform manner in the absence of any magnets and sputtered material plus oxygen form the reactive gas present in the chamber 1 is deposited on to the substrate.

The process of the invention has been used to good effect to coat glass substrates with indium (no reactive gas) and indium oxide (with reactive gas).

In all cases, utilisation of target material was much improved by use of the helicon generated plasma, obviating the need for magnets associated with the target.

The invention has also been used to deposit coatings of iron, nickel and cobalt all of which are magnetic materials.

## Claims

1. A process of depositing thin film coatings by sputtering which comprises
- forming a plasma in an evacuated chamber;
- providing a source of material to be sputtered;
- locating a substrate to be coated in the chamber;
- causing the sputtered material to pass through the plasma and be deposited in the substrate
wherein the plasma is generated by a helicon wave.

2. A process according to Claim 1 in which the helicon wave is produced using a radio frequency of 13.56 MHz.

3. A process according to Claim 1 or Claim 2 in which the pressure in the chamber is from 10⁻² to 10⁻³ mbar.

4. A process according to any preceding claim which comprises reactive sputtering in which a gaseous element or compound present in the chamber is co-deposited with the sputtered material.

5. A process according to any preceding claim in which a substantially uniform magnetic field is effected in a predetermined area of the chamber by means of field coils.

6. A process according to Claim 5 in which at least three field coils are spaced along the length of the relevant part of the chamber.
